# EUROPÄISCHE PATENTSCHRIFT

(11) **EP 1 367 856 B1**
(45) Veröffentlichungstag und Bekanntmachung des Hinweises auf die Patenterteilung: **09.11.2005**
(21) Anmeldenummer: 03010805.4
(22) Anmeldetag: 14.05.2003
(51) Int. Cl.: H04R 25/00

(54) **Vorrichtung und Verfahren zur Feedbackreduktion bei Hörsystemen**
Method and apparatus for feedback reduction in hearing systems
Méthode et appareil pour la réduction de la rétroaction dans des systèmes auditifs

(30) Priorität: 27.05.2002 DE 10223544
(43) Veröffentlichungstag der Anmeldung: 03.12.2003
(73) Patentinhaber: Siemens Audiologische Technik GmbH, 91058 Erlangen (DE)
(72) Erfinder: Beimel, Bernd, 91054 Erlangen (DE); Weidner, Tom, 91056 Erlangen (DE)
(74) Vertreter: Berg, Peter

(56) Entgegenhaltungen:
- EP-A- 0 579 152
- EP-A- 1 119 218
- DE-A- 2 854 912
- DE-B- 1 126 929
- US-A- 6 097 823
- US-A1- 2002 061 113
- PATENT ABSTRACTS OF JAPAN vol. 1997, no. 05, 30. Mai 1997 (1997-05-30) & JP 09 018998 A (RION CO LTD), 17. Januar 1997 (1997-01-17)

## Beschreibung

Die vorliegende Erfindung betrifft eine Verstärkervorrichtung für Hörgeräte mit einer Verstärkungseinrichtung, die einen akustischen und einen induktiven Eingang aufweist, und einer Filtereinrichtung, die an die Verstärkungseinrichtung angeschlossen ist, zur Kompensation einer akustischen Rückkopplung durch Adaption an die akustische Rückkopplung. Darüber hinaus betrifft die vorliegende Erfindung ein Hörgerät mit einer derartigen Verstärkervorrichtung. Ferner betrifft die vorliegende Erfindung ein entsprechendes Verfahren zum Verstärken von Eingangssignalen eines Hörgeräts.

Bei einem Hörgerät werden akustische Eingangssignale über ein Mikrofon aufgenommen, in einer Verstärkervorrichtung verstärkt und die verstärkten Signale einem Lautsprecher zugeführt. Der vom Lautsprecher abgestrahlte Schall wird teilweise zu dem Mikrofon rückgekoppelt, wodurch es zu deutlich wahrnehmbaren Störungen kommt.

Neben dem Mikrofon und dem Lautsprecher weist ein Hörgerät vielfach auch eine sogenannte Telespule zur induktiven Einkopplung von Hörsignalen beispielsweise von einem Telefon auf. Da der Lautsprecher nach dem elektromagnetischen Prinzip arbeitet, kommt es in der Regel zu einer magnetischen Rückkopplung von dem Magneten des Lautsprechers zur Telespule.

Bei Mischbetrieb wird das Mikrofon und die Telespule gleichzeitig betrieben und es liegen mehrere Eingangssignale vor. Dementsprechend kommt es im Mischbetrieb auch zu mehreren Rückkopplungs- beziehungsweise Feedbackpfaden.

Aus der Europäischen Patentanmeldung EP 1 119 218 A1 ist in diesem Zusammenhang eine Vorrichtung zur elektromagnetischen Feedbackreduktion bei Kommunikationsgeräten bekannt. Dabei wird ein digitales Filter dazu verwendet, die kombinierte Impulsantwort der Komponenten D/A-Wandler, Lautsprecher, elektromagnetischer Rückkopplungspfad, Aufnahmespule und A/D-Wandler zu simulieren. Die Koeffizienten des digitalen Filters werden gemäß einem ausgewählten Rückkopplungsschätzalgorithmus eingestellt oder gesetzt.

Weiterhin ist aus der Druckschrift EP 0 579 152 A1 eine Hörhilfe mit adaptiver Filterung sowie Störgeräuschunterdrückung und Rückkoppelungsunterdrückung bekannt. Dabei werden akustische Rückkoppelungen durch ein adaptives Filter kompensiert.

Die Aufgabe der vorliegenden Erfindung besteht darin, die Feedbackreduktion bei Hörgeräten zu verbessern und zu vereinfachen.

Erfindungsgemäß wird diese Aufgabe gelöst durch eine Verstärkervorrichtung für Hörgeräte mit einer Verstärkungseinrichtung, die einen akustischen und einen induktiven Eingang aufweist, und einer ersten Filtereinrichtung, die an die Verstärkungseinrichtung angeschlossen ist, zur Kompensation einer akustischen Rückkopplung sowie einer zweiten Filtereinrichtung, die an die Verstärkungseinrichtung angeschlossen ist und die von der ersten Filtereinrichtung verschieden ist, zur Kompensation einer induktiven Rückkopplung, und eine Datenverbindung zwischen der ersten Filtereinrichtung und der zweiten Filtereinrichtung zur Übertragung von Filterkoeffizienten.

Darüber hinaus wird die oben genannte Aufgabe gelöst durch ein Verfahren zum Verstärken von Eingangssignalen für ein Hörgerät durch Bereitstellen eines akustischen und induktiven Eingangssignals und Kompensieren akustischer Rückkopplungen durch eine erste Filtereinrichtung, Ermitteln von Filterkoeffizienten durch die erste Filtereinrichtung, Übertragen der Filterkoeffizienten von der ersten Filtereinrichtung zu einer zweiten Filtereinrichtung zum Konfigurieren der zweiten Filtereinrichtung und anschließendes Kompensieren einer induktiven Rückkopplung durch eine zweite Filtereinrichtung.

Der Erfindung liegt der Gedanke zugrunde, mehrere Rückkopplungs- beziehungsweise Feedbackpfade über mehrere Kompensationspfade zu kompensieren. Bisherige Feedbackreduktionsverfahren bei Hörgeräten arbeiten nur mit einem internen Kompensationspfad. Bei diesen Verfahren wird stets nur von einem Feedbackpfad ausgegangen. Daher wurden Ansätze oder Verfahren, die sich mit der gleichzeitigen Kompensation (Feedbackreduktion) bei mehreren, gleichzeitig aktiven Feedbackpfaden, wobei einer davon auch nicht akustisch sein kann, mittels mehrerer Kompensationspfade beschäftigen, bislang nicht verfolgt beziehungsweise vorgestellt.

Mit der vorliegenden Erfindung ist es möglich, auf mehrere Feedbackpfade mit eventuell unterschiedlichen Eingangssignalen adäquat zu reagieren. Erfindungsgemäß ist eine getrennte Feedbackkompensation oder -reduktion für die verschiedenen Pfade vorgesehen. Speziell das Problem bei Betrieb der Telespule kann somit durch ein eigenes Kompensationsfilter gut gelöst werden. Insbesondere kann eine induktive Rückkopplung durch ein statisches Filter und eine akustische Rückkopplung durch ein adaptives Filter kompensiert werden.

In vorteilhafter Weise können durch die Kompensation der magnetischen Rückkopplung die relativ teuren und aufwändigen Hörerkapselungen entfallen beziehungsweise die Anordnung der Telespule wäre weniger Einschränkungen unterworfen. Darüber hinaus ist es erfindungsgemäß möglich, den Telespulenpfad mit einem vorhandenen adaptiven Kompensationsfilter nachzubilden, anschließend dessen Koeffizienten auszulesen und diese dann als Voreinstellung für ein zweites statisches bis langsam adaptierendes Kompensationsfilter zu verwenden. Somit bleibt der eigentliche adaptive Kompensator nahezu völlig frei für einen anderen vorzugsweise akustischen Pfad. Somit werden mehrere, meist unabhängige Feedbackpfade, besonders unter Berücksichtigung von nicht akustischen Pfaden bei der erfindungsgemäßen Vorrichtung und bei dem erfindungsgemäßen Verfahren analysiert und zur Kompensation verwendet.

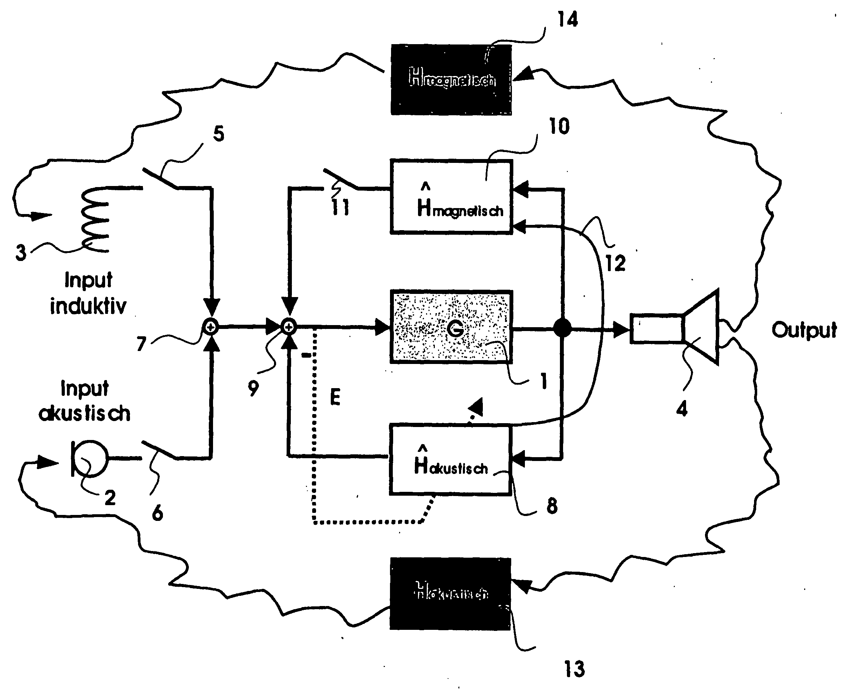

Die vorliegende Erfindung wird nun anhand der beigefügten Zeichnung näher erläutert, die ein Prinzipschaltbild der erfindungsgemäßen Verstärkervorrichtung zeigt.

Das nachfolgende Ausführungsbeispiel stellt eine bevorzugte Ausführungsform der vorliegenden Erfindung dar.

Ein Verstärker 1 ist zwischen ein Mikrofon 2 und eine Telespule beziehungsweise Telefonspule 3 einerseits sowie einen Lautsprecher 4 andererseits geschaltet. Damit verfügt das Hörgerät über einen induktiven und einen akustischen Input bzw. Eingang. Akustische und magnetische Ausgangssignale beziehungsweise Output werden durch den Lautsprecher 4 erzeugt.

Durch einen ersten Schalter 5 kann die Telespule 3 von dem Verstärker 1 abgeschaltet werden. In gleicher Weise kann das Mikrofon 2 durch einen zweiten Schalter 6 von dem Verstärker 1 abgetrennt werden. Die Signale der Telespule 3 und des Mikrofons 2 werden in einem Addierer 7 zusammengeführt und zu dem Verstärker 1 geleitet. Alternativ können die Signale auch separat verstärkt und anschließend addiert werden.

Das Ausgangssignal des Verstärkers 1 wird über ein adaptives Filter 8 an dessen Eingang zurückgekoppelt. In einem Addierer 9 wird das Rückkopplungssignal des adaptiven Filters 8 von dem Summensignal des Addierers 7 subtrahiert. Das adaptive Filter 8 wird laufend anhand des Summensignals E des Addierers 9 an die akustischen Umgebungsbedingungen adaptiert.

Das Ausgangssignal des Verstärkers 1 ist weiterhin über ein statisches Filter 10 an dessen Eingang zurückgekoppelt. Auch dieses Rückkopplungssignal wird in dem Addierer 9 von dem Summensignal des Addierers 7 subtrahiert. Ein dritter Schalter 11 ermöglicht das Auftrennen des Rückkopplungspfads des statischen Filters 10.

Für das Setzen beziehungsweise Einstellen der Filterkoeffizienten im zweiten statischen Filter 10 besteht zu dem adaptiven Filter 8 eine Datenverbindung 12.

Von dem Lautsprecher 4 wird Schall abgestrahlt und über einen akustischen Rückkopplungspfad 13, der die Übertragungsfunktion H_{akustisch} aufweist, zu dem Mikrofon 2 zurückgekoppelt. In gleicher Weise wird ein vom Lautsprecher 4 abgestrahltes Magnetfeld über einen magnetischen Rückkopplungspfad 14, der die Übertragungsfunktion H_{magnetisch} besitzt, zu der Telespule 3 zurrückgekoppelt. Durch die Adaption besitzt das adaptive Filter 8 eine Übertragungsfunktion Ĥ_{akustisch} und das statische Filter 10 eine Übertragungsfunktion Ĥ_{magnetisch}, so dass beide Rückkopplungssignale über den akustischen Pfad 13 und den magnetischen Pfad 14 in geeigneter Weise kompensiert werden können.

Der Grund für die Verwendung eines adaptiven Filters 8 und eines einfachen statischen Filters 10 liegt darin, dass das zweite statische Filter 10 deutlich weniger aufwändig gestaltet werden kann, da der magnetische Rückkopplungspfad weniger dynamisch als der akustische Rückkopplungspfad ist. Die magnetische Rückkopplung ist in der Regel konstant, während sich die akustische Rückkopplung allein dadurch verändern lässt, dass der Hörgeräteträger seine Hand an das Ohr legt. Daher ist es günstig, zwischen dem magnetischen und dem akustischen Rückkopplungspfad zu unterscheiden und für beide unterschiedlich aufwändige Filter zu verwenden.

Darüber hinaus besteht zwischen der akustischen und der magnetischen Rückkopplung ein Laufzeitunterschied, der bei der Filterkompensation zu berücksichtigen ist. Ferner besitzt die akustische Rückkopplung ihren Schwerpunkt in einem höheren Frequenzbereich als die magnetische Rückkopplung. Auch aus diesem Grund ist es angebracht, für beide Rückkopplungen unterschiedliche Kompensationspfade zu verwenden. Ein einziges Filter für beide Kompensationen wäre deutlich aufwändiger als jedes einzelne der beschriebenen Filter 8 und 10.

Es ist zwar möglich, für beide Filter 8 und 10 jeweils ein adaptives Filter zu verwenden, aber aufgrund der geringen Dynamik im magnetischen Rückkopplungspfad genügt zur Kompensation der magnetischen Rückkopplung ein statisches Filter.

Im Folgenden wird das Einstellen beziehungsweise Setzen der Filterkoeffizienten näher dargestellt. Das Filtersystem weist, wie dargestellt, mindestens ein Mikrofon 2, eine Telespule 3, einen Verstärker 1 und einen Hörer beziehungsweise Lautsprecher 4 auf. Weiterhin ist mindestens ein adaptives Feedbackkompensationsfilter 8 und ein adaptives oder statisches Feedbackkompensationsfilter 10 vorhanden. Bei der Fertigung des Geräts oder bei der Anpassung wird auf Telefonspulenbetrieb geschaltet und alle anderen Signaleingänge werden abgeschaltet. Hierzu werden der zweite Schalter 6 und der dritte Schalter 11 geöffnet und der erste Schalter 5 geschlossen. Das adaptive Filter 8 ist somit nur mit dem magnetischen Pfad 14 konfrontiert. Zur Einstellung wird nun die Verstärkung des Verstärkers 1 erhöht, bis das Gerät koppelt oder sich kurz vor der Kopplung befindet. Daraufhin wird das adaptive Feedbackkompensationsfilter 8 aktiviert, bis es die Kopplung unterdrückt hat. Damit wird die Adaption gestoppt und die Koeffizienten werden entweder geräteintern oder mittels einer Übertragung zu oder von einem Anpasscomputer als Voreinstellungen für das zweite im Hörgerät befindliche Feedbackkompensationsfilter 10 abgespeichert. Dieses kann - wie bereits erwähnt - ebenfalls adaptiv sein. Wenn nun während des normalen Betriebs auf Telefonspule umgeschaltet wird, wird das zweite, nun optimal voreingestellte Kompensationsfilter 10 aktiviert. Damit wird der magnetische Feedbackpfad wirkungsvoll kompensiert und das eigentliche adaptive System kann uneingeschränkt für den akustischen Feedbackpfad verwendet werden.

Die Adaption des adaptiven Filters 8 an den akustischen Rückkopplungspfad 13 erfolgt während des Mikrofonbetriebs kontinuierlich. Hierzu werden die Schalter 5 und 11 geöffnet, während der Schalter 6 geschlossen ist.

Im Mischbetrieb, d. h. bei Betrieb des Mikrofons 2 und der Telespule 3 zur Aufnahme von Eingangssignalen werden sämtliche Schalter 5, 6 und 11 geschlossen. In diesem Zustand kompensiert das adaptive Filter 8 den akustischen Rückkopplungspfad 13 und das statische Filter 10 den magnetischen Rückkopplungspfad 14.

## Patentansprüche

1. Verstärkervorrichtung für Hörgeräte mit
einer Verstärkungseinrichtung (1), die einen akustischen und einen induktiven Eingang aufweist, und
einer ersten Filtereinrichtung (8), die an die Verstärkungseinrichtung (1) angeschlossen ist, zur Kompensation einer akustischen Rückkopplung,
**gekennzeichnet durch**
eine zweite Filtereinrichtung (10), die an die Verstärkungseinrichtung (1) angeschlossen ist und die von der ersten Filtereinrichtung (8) verschieden ist, zur Kompensation einer induktiven Rückkopplung und
eine Datenverbindung (12) zwischen der ersten Filtereinrichtung (8) und der zweiten Filtereinrichtung (10) zur Übertragung von Filterkoeffizienten.

2. Verstärkervorrichtung nach Anspruch 1, wobei die erste Filtereinrichtung (8) adaptiv und die zweite Filtereinrichtung (10) statisch ist.

3. Verstärkervorrichtung nach Anspruch 1 oder 2, wobei die beiden Filtereinrichtungen (8, 10) für unterschiedliche Frequenzbereiche ausgelegt sind.

4. Verstärkervorrichtung nach einem der Ansprüche 1 bis 3, wobei die erste Filtereinrichtung (8) in einem ersten Rückkopplungspfad der Verstärkungseinrichtung (1) angeordnet ist.

5. Verstärkervorrichtung nach einem der Ansprüche 1 bis 4, wobei die zweite Filtereinrichtung (10) in einem zweiten Rückkopplungspfad der Verstärkungseinrichtung (1) angeordnet ist.

6. Verstärkervorrichtung nach einem der Ansprüche 1 bis 5, die eine erste Schalteinrichtung (5) an dem induktiven Eingang zum Anschließen an oder Abtrennen von einer induktiven Eingangseinrichtung (3) aufweist.

7. Verstärkervorrichtung nach einem der Ansprüche 1 bis 6, die eine zweite Schalteinrichtung (6) an dem akustischen Eingang zum Anschließen an oder Abtrennen von einer akustischen Eingangseinrichtung (2) aufweist.

8. Verstärkervorrichtung nach einem der Ansprüche 1 bis 7, die eine dritte Schalteinrichtung (11) an der zweiten Filtereinrichtung (10) zum Abschalten der zweiten Filtereinrichtung (10) aufweist.

9. Hörgerät mit einer Verstärkervorrichtung nach einem der Ansprüche 1 bis 8, die zwischen einen induktiven und akustischen Aufnehmer (2, 3) einerseits und einen Lautsprecher (4) andererseits geschaltet ist.

10. Hörgerät nach Anspruch 9, das einen akustischen Rückkopplungspfad zwischen dem Lautsprecher (4) und dem akustischen Aufnehmer (2) aufweist.

11. Hörgerät nach Anspruch 9 oder 10, das einen magnetischen Rückkopplungspfad von dem Lautsprecher (4) zu dem induktiven Aufnehmer (3) aufweist.

12. Verfahren zum Verstärken von Eingangssignalen für ein Hörgerät durch Bereitstellen eines akustischen und induktiven Eingangssignals und
Kompensieren einer akustischen Rückkopplung durch eine erste Filtereinrichtung (8),
**gekennzeichnet durch**
Ermitteln von Filterkoeffizienten **durch** die erste Filtereinrichtung (8),
Übertragen der Filterkoeffizienten von der ersten Filtereinrichtung (8) zu einer zweiten Filtereinrichtung (10) zum Konfigurieren der zweiten Filtereinrichtung und anschließendes
Kompensieren einer induktiven Rückkopplung **durch** die zweite Filtereinrichtung (10).

13. Verfahren nach Anspruch 12, wobei das Kompensieren durch die erste Filtereinrichtung (8) durch Adaption an die akustische Rückkopplung adaptiv und das Kompensieren durch die zweite Filtereinrichtung (10) statisch erfolgt.

14. Verfahren nach Anspruch 12 oder 13, wobei die beiden Filtereinrichtungen (8, 10) in unterschiedlichen Frequenzbereichen die Rückkopplungen kompensieren.

15. Verfahren nach Anspruch 12, 13 oder 14, wobei das Kompensieren der akustischen Rückkopplung in einem ersten Rückkopplungspfad der Verstärkungseinrichtung (1) erfolgt.

16. Verfahren nach einem der Ansprüche 13 bis 15, wobei das statische Kompensieren der induktiven Rückkopplung in einem zweiten Rückkopplungspfad der Verstärkungseinrichtung (1) erfolgt.

17. Verfahren nach Anspruch 16, wobei zur Adaption der ersten Filtereinrichtung (8) das induktive Eingangssignal und der zweite Rückkopplungspfad abgeschaltet werden.

18. Verfahren nach Anspruch 16 oder 17, wobei zur Einstellung der zweiten statischen Filtereinrichtung (10) das akustische Eingangssignal und der zweite Rückkopplungspfad abgeschaltet werden.

## Claims

1. Amplification device for hearing aids with
an amplification device (1) having an acoustic and an inductive input, and
a first filter device (8) connected to said amplification device (1) for compensating acoustic feedback,
**characterised by**
a second filter device (10), different from said first filter device (8), connected to said amplification device (1) for compensating inductive feedback and a data connection (12) between the first filter device (8) and the second filter device (10) for transmitting filter coefficients.

2. Amplification device according to claim 1, with which the first filter device (8) is adaptive and the second filter device (10) static.

3. Amplification device according to claim 1 or 2, with which the two filter devices (8, 10) are designed for different frequency areas.

4. Amplification device according to one of claims 1 to 3, with which the first filter device (8) is arranged in a first feed back path of the amplification device (1).

5. Amplification device according to one of claims 1 to 4, with which the second filter device (10) is arranged in a second feed back path of the amplification device (1).

6. Amplification device according to one of claims 1 to 5, comprising a first switch (5) connected to the inductive input for connecting or disconnecting to and from said inductive input device.

7. Amplification device according to one of claims 1 to 6, comprising a second switch (6) connected to the acoustic input for connecting or disconnecting to and from said inductive input device (2).

8. Amplification device according to one of claims 1 to 7, comprising a third switch (11) connected to the second filter device (10) for disconnecting the second filter device (10).

9. Hearing aid with an amplification device according to one of claims 1 to 8, which is connected on one hand between an inductive and acoustic receiver (2, 3) and on the other hand a loudspeaker (4).

10. Hearing aid according to claim 9, comprising an acoustic feedback path between the loudspeaker (4) and the acoustic receiver (2).

11. Hearing aid according to claim 9 or 10, comprising a magnetic feed back path from the loudspeaker (4) to the inductive receiver (3).

12. Method for amplification of input signals for a hearing aid by providing an acoustic and inductive input signal and compensating an acoustic feed back through a first filter device (8),
**characterised in** by
determining filter coefficients by means of the first, filter device (8),
transmitting the filter coefficients from the first filter device (8) to a second filter device (10) for configuring the second filter device and finally
compensating an inductive feedback with the second filter device (10).

13. Method according to claim 12, in which the compensation with the first filter device (8) takes place adaptively by adaptation to the acoustic feedback and statically with the second filter device (10).

14. Method according to claim 12 or 13, with which the two filter devices (8, 10) compensate the feedbacks in different frequency ranges.

15. Method according to claim 12, 13, or 14, with which the compensation of the acoustic feedback takes place in a first feedback path of the amplification device (1).

16. Method according to one of claims 13, 15, with which the static compensation of the inductive feedback takes place in a second feedback path of the amplification device (1).

17. Method according to claim 16, with which the inductive input signal and the second feedback path are disconnected for adaptation of said first filter device (8)

18. Method according to claim 16 or 17, with which the acoustic input signal and the second feedback path are disconnected in order to adjust the second static filter device (10).

## Revendications

1. Dispositif amplificateur pour appareils auditifs avec
un dispositif amplificateur (1) qui comporte une entrée acoustique et une entrée inductive, et
un premier dispositif de filtrage (8) qui est raccordé au dispositif amplificateur (1) et qui est destiné à la compensation d'une rétroaction acoustique,
**caractérisé par**
un deuxième dispositif de filtrage (10) qui est raccordé au dispositif amplificateur (1), qui est différent du premier dispositif de filtrage (8) et qui est destiné à la compensation d'une rétroaction inductive, et
une liaison de données (12) entre le premier dispositif de filtrage (8) et le deuxième dispositif de filtrage (10) pour la transmission de coefficients de filtrage.

2. Dispositif amplificateur selon la revendication 1, le premier dispositif de filtrage (8) étant adaptatif et le deuxième dispositif de filtrage (10) étant statique.

3. Dispositif amplificateur selon la revendication 1 ou 2, les deux dispositifs de filtrage (8, 10) étant conçus pour des plages de fréquences différentes.

4. Dispositif amplificateur selon l'une des revendications 1 à 3, le premier dispositif de filtrage (8) étant placé dans une première voie de rétroaction du dispositif amplificateur (1).

5. Dispositif amplificateur selon l'une des revendications 1 à 4, le deuxième dispositif de filtrage (10) étant placé dans une deuxième voie de rétroaction du dispositif amplificateur (1).

6. Dispositif amplificateur selon l'une des revendications 1 à 5, qui comporte un premier dispositif interrupteur (5) sur l'entrée inductive pour la connexion ou la déconnexion d'un dispositif d'entrée inductif (3).

7. Dispositif amplificateur selon l'une des revendications 1 à 6, qui comporte un deuxième dispositif interrupteur (6) sur l'entrée acoustique pour la connexion ou la déconnexion d'un dispositif d'entrée acoustique (2).

8. Dispositif amplificateur selon l'une des revendications 1 à 7, qui comporte un troisième dispositif interrupteur (11) sur le deuxième dispositif de filtrage (10) pour la coupure du deuxième dispositif de filtrage (10).

9. Appareil auditif avec un dispositif amplificateur selon l'une des revendications 1 à 8, qui est branché entre un capteur inductif et acoustique (2, 3) d'une part et un haut-parleur (4) d'autre part.

10. Appareil auditif selon la revendication 9, qui comporte une voie de rétroaction acoustique entre le haut-parleur (4) et le capteur acoustique (2).

11. Appareil auditif selon la revendication 9 ou 10, qui comporte une voie de rétroaction magnétique du haut-parleur (4) au capteur inductif (3).

12. Procédé pour amplifier des signaux d'entrée pour un appareil auditif en fournissant un signal d'entrée acoustique et inductif et en compensant une rétroaction acoustique au moyen d'un premier dispositif de filtrage (8),
**caractérisé par**
la détermination de coefficients de filtrage par le premier dispositif de filtrage (8),
la transmission des coefficients de filtrage du premier dispositif de filtrage (8) à un deuxième dispositif de filtrage (10) pour la configuration du deuxième dispositif de filtrage
puis la compensation d'une rétroaction inductive au moyen du deuxième dispositif de filtrage (10).

13. Procédé selon la revendication 12, dans lequel la compensation au moyen du premier dispositif de filtrage (8) s'effectue de manière adaptative par adaptation à la rétroaction acoustique et la compensation au moyen du deuxième dispositif de filtrage (10) s'effectue de manière statique.

14. Procédé selon la revendication 12 ou 13, dans lequel les deux dispositifs de filtrage (8, 10) compensent les rétroactions dans des plages de fréquences différentes.

15. Procédé selon la revendication 12, 13 ou 14, dans lequel la compensation de la rétroaction acoustique s'effectue dans une première voie de rétroaction du dispositif amplificateur (1).

16. Procédé selon l'une des revendications 13 à 15, dans lequel la compensation statique de la rétroaction inductive s'effectue dans une deuxième voie de rétroaction du dispositif amplificateur (1).

17. Procédé selon la revendication 16, dans lequel, pour l'adaptation du premier dispositif de filtrage (8), on coupe le signal d'entrée inductif et la deuxième voie de rétroaction.

18. Procédé selon la revendication 16 ou 17, dans lequel, pour le réglage du deuxième dispositif de filtrage (10) statique, on coupe le signal d'entrée acoustique et la deuxième voie de rétroaction.
